# EUROPEAN PATENT APPLICATION

(11) **EP 1 696 471 A1**
(43) Date of publication of application: **30.08.2006**
(21) Application number: 04820198.2
(22) Date of filing: 07.12.2004
(51) Int. Cl.: H01L 21/027

(54) **PATTERN-FORMING PROCESS UTILIZING NANOIMPRINT AND APPARATUS FOR PERFORMING SUCH PROCESS**

(30) Priority: 11.12.2003 JP 2003413513
(71) Applicant: Tokyo University of Agriculture and Technology Tlo Co., Ltd., Koganei-shi, Tokyo 184-8588 (JP)
(72) Inventor: TAKAKI, Yasuhiro, c/o Tokyo University, Koganei-shi, Tokyo 184-8588 (JP)
(74) Representative: Andrews, Timothy Stephen
(86) International application number: PCT/JP2004/018196
(87) International publication number: WO 2005/057634

(57) **Abstract**

An object of the present invention is to provide a pattern forming method that solves the problems associated with thermal nanoimprinting lithography. The present invention discloses a method for forming a pattern in a resist film on a substrate by using a first mold provided with concave and convex portions, comprising the steps of: (1) pressing the first mold onto the resist film to transfer the concave and convex portions of the first mold to the resist film, while heating the first mold to a predetermined temperature or after having heated the first mold to a predetermined temperature; (2) separating the first mold from the resist film; and (3) etching the resist film to expose a surface of the substrate.

## Description

### Technical Field

The present invention relates to a microfine pattern formation technology. More particularly, the present invention relates to a patterning method in a semiconductor device and a device for carrying out the method.

### Background Art

Further advances are required in the fields of network technology, software technology and device technology due to the recent progress achieved in the field of IT technology. Consequently, with respect to semiconductor devices in particular, even more sophisticated technologies are required for high-speed operation through the use of even finer devices, reduced power consumption and integration of functions referred to as system LSI. In consideration of these circumstances, although lithography has served as the core technology for the production of semiconductor devices, as the use of even finer devices continues to progress, the devices required by such technology are becoming increasingly expensive.

Nanoimprinting technology is an example of a technology that offers both semiconductor structure patterning of 100 nm (nanometers) or less and productivity during semiconductor production (see, for example, US Patent No. 5,772,905). In this technology, a nano-sized pattern mold is formed and this mold is then pressed onto a heated resist film to form a microfine pattern in the resist.

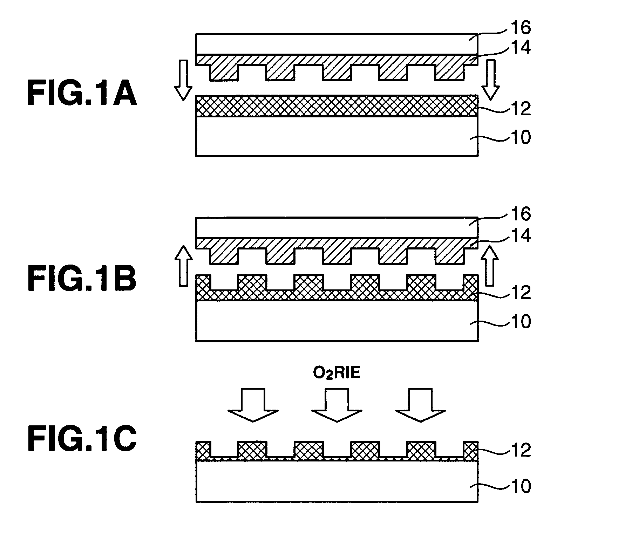

Fig. 1 shows a series of schematic cross-sectional views for explaining each step of microfine pattern formation using nanoimprinting of the prior art. As shown in Fig. 1(a), a pattern forming resist 12 of polymethyl methacrylate and so forth is coated onto a wafer 10, while a mold 14 is arranged on a mold base 16. Next, as shown in Fig. 1(b), by pressing the mold 14 onto resist 12, mold 14 transfers the concave and convex surface pattern in the surface thereof to resist 12. During this transfer, although not shown in the drawings, resist 12 is heated by heating wafer 10 to about 200°C, and mold 14 is pressed onto resist 12 while it is softened. Subsequently, by cooling the wafer while it retains the pressed shape, the irregular surface pattern of mold 14 is transferred to resist 12 and the mold base 16 is moved upward. Then, as shown in Fig. 1(c), in the case where a film thickness of resist 12 is greater than a height of the convex portions of mold 14, etching is carried out on resist film 12 by anisotropic reactive ion etching (indicated as RIE in Fig. 1) to expose the surface of wafer 10 in the concave portions of the resist pattern. Subsequently, etching is carried out using this resist film as a mask. Alternatively, Al and so forth may be vapor-deposited and then lifted off for use in wiring.

Since this pattern formation method consists of applying heat to the resist, pressing the mold onto the resist and then cooling when forming a pattern, it is referred to as thermal nanoimprinting lithography. In this method, nanoimprinting technology is known to be extremely useful since it offers the advantage of being able to collectively mold patterns on the order of 25 nm or less.

### Disclosure of Invention

In nanoimprinting methods of the prior art, however, since the wafer and resist film on the wafer are repeatedly heated and cooled, there is the problem of requiring a considerable amount of time to form a pattern on the resist. More specifically, in the method of the prior art shown in Fig. 1, pattern formation has been reported to take about 2 hours. Moreover, the thermal nanoimprinting lithography method leads to problems such as a decrease in the overall throughput of semiconductor production, dimensional changes in the transferred pattern and decreased accuracy caused by temperature differences, and decreased alignment of the device due to thermal expansion.

With the foregoing in view, a first object of the present invention is to provide a pattern formation method that resolves problems associated with the thermal nanoimprinting lithography method.

In addition, since accuracy at the nanometer level is required for the positional relationship between the mold and resist film and particularly for maintaining parallelism between the mold surface and resist surface, a second object of the present invention is to provide a pattern formation method that maintains highly accurate positioning of the mold and resist film. Moreover, a third object of the present invention is to provide a device for carrying out this pattern formation method.

As a result of conducting extensive studies on nanoimprinting technology, the present inventor has found that the above-mentioned problems can be solved by pressing a mold onto a resist film on a substrate in the form of a wafer while heating the mold, thereby leading to completion of the present invention. Moreover, the present inventor has also found that by positioning the mold and the resist film using their own weights by superimposing in the direction of gravity when positioning the mold and resist film, parallelism between the mold surface and resist surface is maintained, thereby leading to completion of the present invention.

Namely, the first object is achieved by a method for forming a pattern in a resist film on a substrate by using a first mold provided with concave and convex portions, comprising the steps of: (1) pressing the first mold onto the resist film to transfer the concave and convex portions of the first mold to the resist film, while heating the first mold to a predetermined temperature or after having heated the first mold to a predetermined temperature; (2) separating the first mold from the resist film; and (3) etching the resist film to expose a surface of the substrate. According to this constitution, transfer can be carried out in a short period of time since a heated mold is pressed onto the resist film.

According to a preferable aspect of the present invention, in the above-mentioned method, the pressing step is carried out so that a bottom of the concave portion avoids contacting with a surface of the resist film. Since the bottom of the concave portion of the mold is not allowed to contact a surface of the resist film, there is no occurrence of defective separation of the mold caused by the bottom of the concave portion of the mold being pressed onto the resist surface in the subsequent separation step, thereby enabling highly accurate transfer.

According to a preferable aspect of the present invention, in the above-mentioned method, a hardness of the first mold is higher than a hardness of the resist film. Rapid transfer is realized by utilizing this difference in hardness.

According to a preferable aspect of the present invention, in the above-mentioned method, the predetermined temperature of the first mold in the pressing step is equal to or substantially equal to a glass transition temperature of the resist film. The mold temperature can be suitably controlled relative to the glass transition temperature of the polymer material that constitutes the resist film, so as to enable rapid transfer.

According to a preferable aspect of the present invention, the first mold in the above-mentioned method comprises silicon or is formed by electroforming using the silicon as a master.

According to a preferable aspect of the present invention, the resist film comprises a thermoplastic resin in the above-mentioned method.

According to a preferable aspect of the present invention, the etching step is carried out by reactive ion etching in the above-mentioned method.

According to a preferable aspect of the present invention, in the above-mentioned method, in a case where there are variations in pattern density of a pattern to be formed in the resist film on the substrate by the first mold, the method comprises a pretreatment step in which the resist film is pressed in advance using a second mold so that a thickness of the resist film in a case where numerous regions pressed by the convex portions of the first mold exist is less than a thickness of the resist film in a case where few regions pressed by the convex portions of the first mold exist. As a result of carrying out this pretreatment step, pattern formation can be carried out with high accuracy even if there are variations in pattern density of a pattern to be formed.

According to a preferable aspect of the present invention, the second mold in the pretreatment step of the above-mentioned method is pressed onto the resist film while heating the second mold to a predetermined temperature or after having heated the second mold to a predetermined temperature.

According to a preferable aspect of the present invention, in the above-mentioned method, a hardness of the second mold is higher than a hardness of the resist film.

According to a preferable aspect of the present invention, the predetermined temperature of the second mold in the pretreatment step of the above-mentioned method is equal to or substantially equal to the glass transition temperature of the resist film.

According to a preferable aspect of the present invention, in the above-mentioned method, the second mold comprises silicon or is formed by electroforming using the silicon as a master.

The second object of the present invention is achieved by a method for forming a pattern in a resist film on a substrate by using a mold provided with concave and convex portions, comprising the steps of: (a) arranging the mold on a vertically moving actuator; (b) mounting the substrate on a sample base arranged in opposition to the actuator so as to oppose the mold; (c) mounting the substrate on the mold; (d) supporting the sample base having the substrate by a support; and (e) moving the actuator so that the mold moves away from the resist film. According to this method, since s shape of the concave and convex portions of the mold are transferred to the resist film while maintaining parallelism between the mold surface and resist surface, the shape of the concave and convex portions of the mold can be transferred with high accuracy.

According to a preferable aspect of the present invention, the above-mentioned method further comprises a step (f) of moving the actuator so that the mold and the resist film make contact while heating the mold to a predetermined temperature or after having heated the mold to a predetermined temperature. Transfer can be carried out rapidly by contacting the heated mold to the resist film.

According to a preferable aspect of the present invention, the above-mentioned method further comprises a step (g) of moving the actuator so that the mold separates from the resist film.

According to a preferable aspect of the present invention, the above-mentioned method further comprises a step (h) of etching the resist film to expose a surface of the substrate. This etching step allows a pattern to be formed on the substrate.

According to a preferable aspect of the present invention, step (f) of the aforementioned method is carried out so that a bottom of the concave portion of the mold avoids contacting with a surface of the resist film. Since the bottom of the concave and convex portions of the mold are not allowed to contact the surface of the resist film, there is no occurrence of defective separation of the mold caused by the bottom of the concave portion of the mold being pressed onto the resist surface in the subsequent separation step, thereby enabling highly accurate transfer.

According to a preferable aspect of the present invention, in the above-mentioned method, a hardness of the mold is higher than a hardness of the resist film. Rapid transfer is realized by utilizing this difference in hardness.

According to a preferable aspect of the present invention, in the above-mentioned method, the predetermined temperature of the mold is equal to or substantially equal to the glass transition temperature of the resist film. This temperature can be used to enable rapid transfer.

According to a preferable aspect of the present invention, the mold in the above-mentioned method comprises silicon or is formed by electroforming using the silicon as a master.

According to a preferable aspect of the present invention, the resist film comprises a thermoplastic resin.

Moreover, the third object of the present invention is achieved by a pattern formation device for forming a pattern in a resist film on a substrate using a mold provided with concave and convex portions, comprising: a sample base for mounting the substrate; a first actuator arranged in opposition to the sample base for moving the mold; at least two supports for supporting the sample base; a second actuator arranged on the support for vertically moving the sample base; and a monitoring unit for monitoring a contact between the support and the sample base. The pattern formation method as claimed in the present invention can be carried out with this device.

According to a preferable aspect of the present invention, in the above-mentioned device, the monitoring unit monitors an amount of current flow by using the support and sample base as conductors and connecting a power supply therebetween. The positional relationship between the sample base provided with the substrate having the resist film and the mold for pattern formation can be controlled by this monitoring.

According to a preferable aspect of the present invention, the power supply in the above-mentioned device is an alternating current power supply. The use of an alternating current power supply makes it possible to eliminate the effects of noise.

Note that the term "nanometer level" used in the present specification refers to a size of 1 µm or less and 1 nanometer (1/10⁹ meter) or more. In addition, the term "temperature equal to or substantially equal to the glass transition temperature of the resist film" refers to a temperature that is sufficient for softening of the resist film.

### Advantageous Effect of Invention

The pattern formation method according to the present invention realizes transfer of patterns formed at the nanometer level to a resist film on a substrate an extremely short period of time as compared to an amount of time required by pattern formation methods of the prior art. More specifically, a single transfer can be carried out in only a few seconds.

In addition, the pattern formation method according to the present invention is capable of transferring patterns formed at the nanometer level even when there are variations in pattern density of the resist pattern on a single substrate by carrying out pretreatment on the resist film on the substrate comprising adjusting the thickness of the resist film according to the variations in pattern density in the case of variations in pattern density of the pattern to be formed on a single substrate.

Moreover, the pattern formation method according to the present invention realizes transfer of patterns formed at the nanometer level while maintaining parallelism between the surface of the resist film and the surface of the mold substantially constant.

In addition, according to the pattern formation device in the present invention, a device is provided that is capable of pattern formation at the nanometer level.

### Brief Description of the Drawings

Fig. 1 shows schematic cross-sectional views for explaining each step of micropattern formation using nanoimprinting according to the prior art;
Fig. 2 shows schematic cross-sectional views of each step for explaining a first embodiment of the pattern formation method according to the present invention;
Fig. 3 shows schematic cross-sectional views of each step for explaining a second embodiment of the pattern formation method according to the present invention. Note that the mold base for arranging the mold is omitted in Fig. 3;
Fig. 4 shows a flow chart for explaining the pattern formation method according to another embodiment of the present invention;
Fig. 5 shows schematic cross-sectional views for explaining the steps of a pattern formation method according to a third embodiment of the present invention;
Fig. 6 shows a schematic cross-sectional view of a pattern formation device for carrying out the pattern formation method embodying one embodiment of the present invention;
Fig. 7 shows an SEM micrograph (magnification factor: 5000x) of a pattern formed using a resist film thickness of 1 µm; and,
Fig. 8 shows an SEM micrograph (magnification factor: 10,000x) of a pattern formed according to the pattern formation method of the present invention using a resist film thickness of 200 nm.

### Best Mode for Carrying Out the Invention

Although the following description provides a detailed explanation of preferred embodiments of the present invention with reference to the drawings, the present invention is not limited to the following embodiments. The present invention can be worked in various forms provided they do not depart from the gist and the spirit thereof.

### First Embodiment

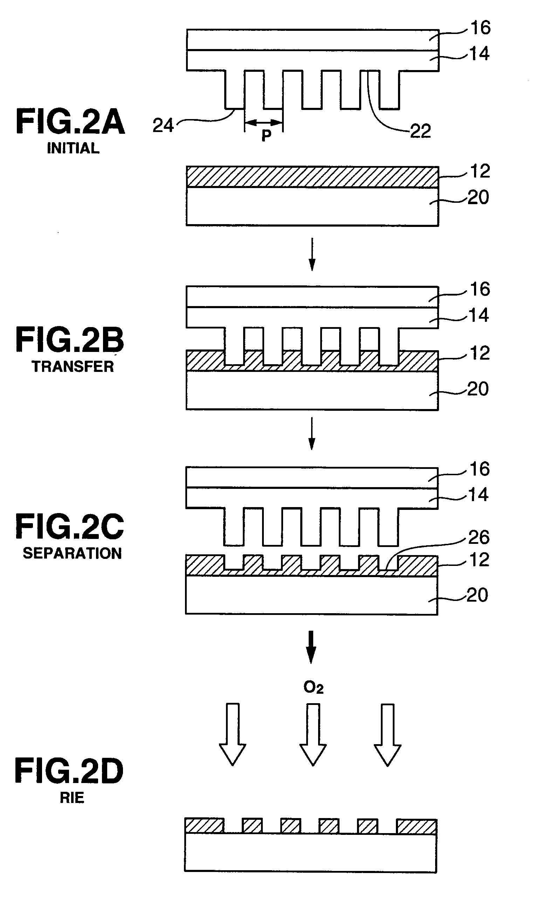

Fig. 2 shows a schematic cross-sectional view of each step for explaining a first embodiment of the pattern formation method according to the present invention. As shown in step (a) of Fig. 2, a film-like resist film 12 is first formed on a substrate 20, while a pattern forming mold 14 provided with predetermined concave and convex portions is disposed on a mold base 16.

The substrate 20 used in the present invention may be a thin sheet having a smooth surface formed of a semiconductor, metal materials or polymer material, and is preferably a silicon substrate 20. On the other hand, the resist film 12 formed on the substrate 20 may be that which contains a polymer material, and from the viewpoint of transfer technology using heat to be described later, is preferably a material that contains a thermoplastic resin. Specific examples of thermoplastic resins include, but are not limited to, polymers formed by an addition polymerization reaction such as polyethylene, polystyrene, poly(meth)acrylate or polyvinyl chloride, and polymers formed by a polycondensation reaction such as polyester, polyamide, polycarbonate or polyurethane or the like. In addition, these polymers can be used for the resist material either alone or in combination.

As shown in Fig. 2(a), examples of methods for forming the resist film 12 on the substrate 20 include, but are not limited to, a method in which a solution in which the above-mentioned polymer material is dissolved or dispersed in a suitable solvent is spin-coated onto the substrate 20.

Examples of pattern forming mold 14 used in the present invention include a silicon mold produced by anisotropic etching so as to be provided with predetermined concave and convex portions, or a mold produced by electroforming by using the silicon mold as a master, such as a mold made of copper, nickel or alloy thereof. The production method of this mold can be easily understood by a person with ordinary skill in the art as disclosed in, for example, Japanese Patent Application Laid-open No. H5-287577. Note that, in order to carry out the transfer step to be described later more efficiently, a hardness of the mold 14 is preferably higher than a hardness of the resist film 12. This is because it becomes easier for mold 14 to be pressed into the resist film 12 when pressing the mold 14.

As shown in Fig. 2(a), the transfer step to be described later is carried out while heating or after having heated the mold 14 to a predetermined temperature. At that time, the temperature of the mold 14 is preferably a temperature at which the resist film 12 can be softened. More specifically, the predetermined temperature when the mold 14 is heated can be suitably set according to the polymer material that constitutes the resist film 12, and is preferably equal to or substantially equal to the glass transition temperature of the polymer material. For example, in a case where poly(methyl methacrylate) is used for the resist film 12, since the glass transition temperature thereof is about 72°C, the mold is preferably heated to that temperature or a temperature roughly equal thereto. In addition, in a case where polycarbonate is used for the resist film, since the glass transition temperature thereof is about 150°C, the mold 14 is preferably heated to that temperature or a temperature roughly equal thereto. Furthermore, heating of the mold 14 can be carried out by a heating means not shown as can be easily understood by a person with ordinary skill in the art. A specific example of a heating means is a ceramic heater, the temperature range imparted to the mold 14 by this heating means is preferably a temperature equal to or substantially equal to the glass transition temperature of the resist film as was previously stated.

As shown in step (b) in Fig. 2, after heating or having heated the mold 14 to a temperature equal to or substantially equal to the glass transition temperature of the resist film 12 formed on the substrate 20, the mold 14 is pressed onto the resist film 12 so as to make contact from the surface of resist film 12. Here, when pressing the mold 14 onto the resist film 12, contact between the bottoms 22 of the concave portion in the mold 14 and the surface of the resist film is preferably avoided. As a result of avoiding in this manner, the advantage is obtained of eliminating defective separation of the mold 14 caused by the bottoms 22 being pressed onto the resist surface.

As was previously described, since the mold 14 is heated to a temperature equal to or substantially equal to the glass transition temperature of resist film 12, the mold 14 easily advances towards the surface of substrate 20 with respect to resist film 12 as shown in Fig. 2(b).

As shown in step (c) in Fig. 2, after having pressed the mold 14 onto the resist film 12 in step (b), the mold 14 is separated from the resist film 12 towards the upward direction. As a result of employing this method, a predetermined pattern is formed on resist film 12. At this time, although the resist film itself is also heated since the mold 14 itself is still hot, since the mold 14 is separated from resist film 12 after pressing the mold 14, the resist film 12 is cooled rapidly.

As a result of pressing the shape of a mold having concave and convex portions on its surface onto a resist film to cause the resist film to be deformed in this manner, a shape matching the concave and convex portions can be transferred to the resist film.

Next, in step (d) in Fig. 2, a resist film 26 remaining on substrate 20 is removed by etching to expose a surface of substrate 20. Specific examples of methods for etching the residual film that can be used include oxygen reactive ion etching shown in step (d) of Fig. 2, and wet etching using chemicals.

As was previously described, the pattern formation method according to the present invention enables high-throughput production by enabling pattern transfer using only the tips of the concave and convex portions of the mold.

### Second Embodiment

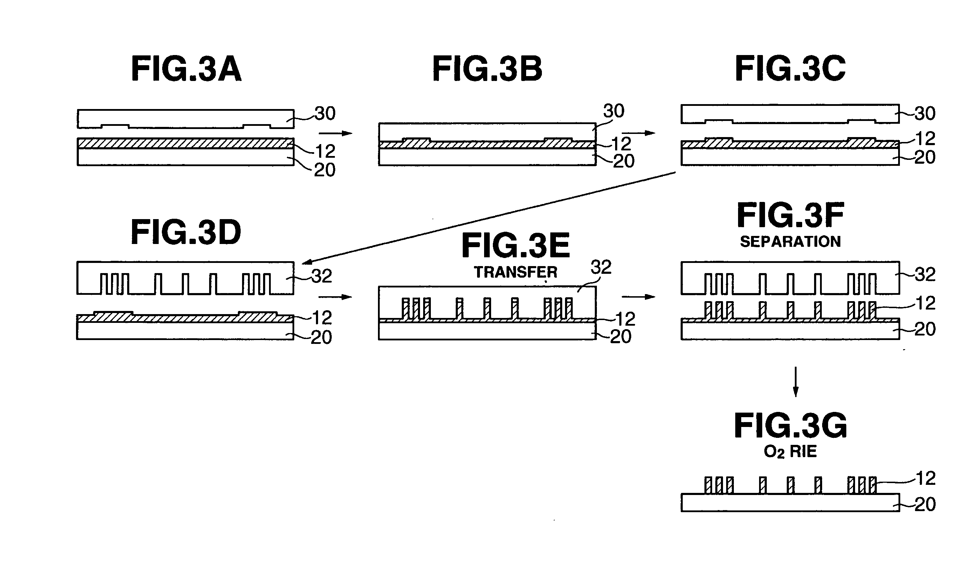

Fig. 3 shows schematic cross-sectional views of each step for explaining a second embodiment of the pattern formation method according to the present invention. The pattern formation method according to the present invention shown in Fig. 3 is a method for accurately forming a pattern when there are variations in pattern density ultimately formed on a single substrate.

In the second embodiment according to the present invention, pretreatment is carried out so that a thickness of a resist film in the case where there are numerous regions pressed by the convex portions of the first mold is less than a thickness of a resist film in the case where there are few regions pressed by the convex portions of the first mold. As a result of adjusting the film thickness in this manner, an adjustment step is carried out on the resist film in advance in accordance with the variations in pattern density of the pattern to be formed prior to the previously described first embodiment.

Note that a case of the pattern to be formed having variations in pattern density refers to a case in which the convex portions of the mold are not provided in an orderly manner at fixed intervals, and the pattern to be formed becomes dense when the number of convex portions is relatively large. On the other hand, the pattern to be formed becomes sparse when the number of the convex portions of the mold is relatively small.

Specifically, as shown in Fig. 3(a), a pretreatment mold 30 is prepared. This mold 30 has concave and convex portions on the surface thereof corresponding to the variations in pattern density of the pattern to be subsequently formed. More specifically, the concave and convex surface pattern in the mold 30 are designed so that the convex portion of the mold 30 are made to correspond to the region in which the pattern to be formed is sparse so that the film thickness of resist film 12 is thin, while the convex portion of the mold 30 are made to correspond to the region in which the pattern to be formed is dense so that the film thickness of resist film 12 is thicker than the sparse region. The shape of the pattern ultimately formed is adjusted by controlling the film thickness of the resist film 12 in advance using this mold 30.

In the case of pretreatment for controlling the film thickness of the resist film 12 using the mold 30 (see step (b) in Fig. 3), the mold 30 is pressed onto the resist film 12. In order to carry out this pressing efficiently, a hardness of the mold 30 is preferably higher than a hardness of the resist film 12. Moreover, in order to carrying out pressing even more efficiently, the mold 30 is preferably heated to a temperature equal to or substantially equal to the glass transition temperature of the resist film. As a result, as shown in Fig. 3(c), the film thickness of the resist film 12 can be controlled according to the regions of variations in pattern density of the pattern to be subsequently formed by separating the mold 30 from the resist film 12.

Returning to the explanation of the pattern formation method of the second embodiment according to the present invention shown in Fig. 3, since steps (d) to (g) of Fig. 3 are the same as steps (a) to (d) in Fig. 2, an explanation of steps (d) to (g) in Fig. 3 is omitted.

According to each step explained with Fig. 3, a pattern can be formed at the nanometer level even in the case where there are variations in pattern density of the pattern to be formed on a single substrate.

### Third Embodiment

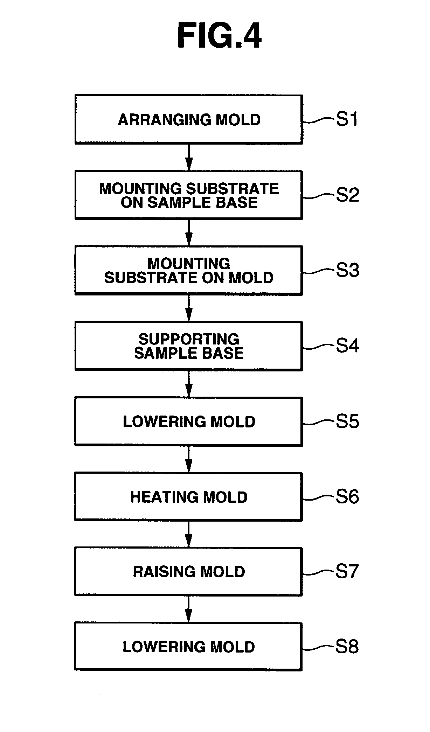

Fig. 4 shows a flow chart for explaining the pattern formation method according to another embodiment of the present invention. As shown in Fig. 4, a pattern formation method according to a third embodiment of the present invention comprises the steps of: arranging a mold (S1); arranging a substrate on a sample base (S2); mounting the substrate on the mold (S3); supporting the sample base (S4); lowering the mold (S5); heating the mold (S6); raising the mold (S7); and lowering the mold (S8). Each step is explained together with cross-sectional views that explain the pattern formation method to be described later.

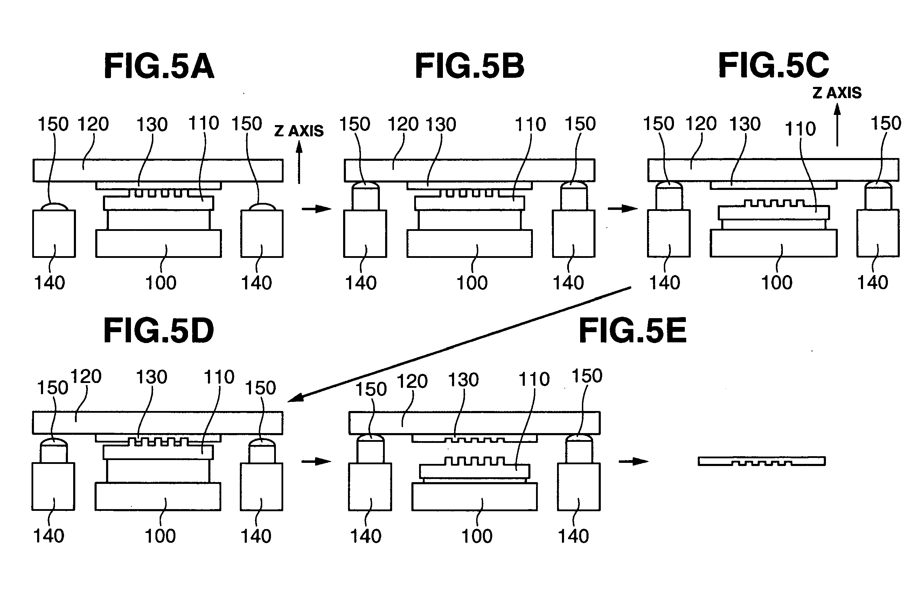

Fig. 5 shows schematic cross-sectional views for explaining the steps of a pattern formation method according to the third embodiment of the present invention. In Fig. 5(a), a mold 110 provided with concave and convex portions is arranged on an actuator 100 capable of moving in the direction of the z axis, while a substrate 130, such as a silicon wafer, having a resist film is mounted on a substrate base 120 arranged in opposition to the actuator (corresponding to steps S1 and S2 in Fig. 4). Next, the substrate 130 is mounted on the mold 110 together with the sample base 120 (see Step S3 in Fig. 4). In this manner, the actuator 100, the mold 110 and the sample base 120 are positioned by their own weight by superimposing them in the direction of gravity utilizing the weight of the substrate 130 and the sample base 120.

In Fig. 5(b), the supports 140 that support the sample base 120 are moved upward from below in Fig. 5 to support the sample base 120 from the vicinity of both ends (corresponding to Step S4 in Fig. 4). Although at least two supports 140 are shown in Fig. 5, three or more supports may be used to support the sample base 120 in a stable manner. The supports 140 used in the present invention are provided with an actuator 150 on the ends thereof, and vertically movable supporting rods and so forth are provided with respect to the direction of the z axis. Next, as shown in Fig. 5(c), the actuator 110 on which the mold 110 is mounted is lowered downward in the direction of the z axis while the supports 140 support the sample base 120 on which the substrate 130 having the resist film is arranged (see Step S5 in Fig. 4). During this lowering, it is necessary to lower to a sufficient distance so that there are no effects of heat on the resist film when the mold 110 is heated as will be described later.

In this manner, in the present invention, the actuators having a highly precise linear resolution are required for movement in the vertical direction of the mold 110 and the sample base 120. A specific example of the actuator 100 used in the present invention includes a stepping motor actuator (movement width: 25 mm, resolution: 25 nm, PI-Polytech Model M168), or the like. On the other hand, a preferable example of the actuator 150 used in the present invention is the piezo actuator disclosed in US Patent No. 5,410,206, specific examples of which include the Model 8301, 8302, 8303, 8321 or 8322 manufactured by New Focus Inc. having a linear resolution of 30 nm or less.

Next, the mold 110 is heated using a heater or the like not shown in the drawings (corresponding to Step S6 in Fig. 4). When the mold is pressed onto the resist film, the heating temperature is preferably equal to or substantially equal to the glass transition temperature of the resist film from the viewpoint of facilitating mold transfer. In addition, the polymer resin that constitutes the resist film is preferably a thermoplastic resin. Specific examples of the thermoplastic resins include, but are not limited to, polymers formed by an addition polymerization reaction such as polyethylene, polystyrene, poly(meth)acrylate or polyvinyl chloride, and polymers formed by a polycondensation reaction such as polyester, polyamide, polycarbonate or polyurethane. In addition, these polymers can be used for the resist material either alone or in combination. For example, in a case where poly(methyl methacrylate) is used for the resist film, since the glass transition temperature thereof is about 72°C, the mold 110 is preferably heated to that temperature or a temperature substantially equal thereto. In a case where polycarbonate is used for the resist film, since the glass transition temperature thereof is about 150°C, the mold 110 is heated is preferably heated to that temperature or a temperature roughly equal thereto.

In Fig. 5(d), the heated mold 110 is moved upward in the direction of the z axis using the actuator and presses onto the resist film of the substrate 130 (see Step S7 in Fig. 4). During this pressing, the mold 110 is preferably pressed so that contact by the bottoms of the concave and convex portions of the mold 110 with the surface of the resist film is avoided. As a result of pressing in this manner, only the tips of the concave and convex portions of the mold 110 are allowed to transfer the pattern to the resist film, thereby realizing a pattern formation method having high throughput.

Next, as shown in Fig. 5(e), the actuator 100 is operated so that the mold 110 is separated from the resist film to complete pattern transfer (Step S8 in Fig. 4). As was previously described, since the mold 110 is pressed onto the resist film so that the resist film does not penetrate into the bottom of the mold 110, in the separation step shown in Fig. 5(e), the resist film does not remain on the bottoms of the concave and convex portions thereof, thereby making it possible to eliminate the risk of causing deformation of the transferred pattern.

Patterns can be transferred to larger substrates by carrying out transfer a plurality of times by repeating the steps shown in Figs. 5(a) to 5(e) after having changed the relative position of the mold 110 or the sample base 120 according to need.

It should be noted that, if positioning to determine parallelism between the resist film on the substrate 130 mounted on the sample base 120 and the surface of mold 110 is carried out each time a pattern is transferred, the production throughput of pattern formation decreases. However, there is little variation in the thickness of the resist film and thickness of the substrate. In addition, rather than adjusting parallelism during pattern transfer, the sample base 120 is raised slightly from supports 140 followed by repositioning according to contact between the surface of the resist film and the surface of the mold in order to move the mold upward more than the depth of the pattern that is formed,

Following completion of transfer, the substrate 130 is removed from the sample base 120 to obtain a substrate provided with a resist film to which the pattern of the concave and convex portions of the mold 110 has been transferred. Subsequently, a desired pattern is formed on the substrate by etching the resist film so as to expose the surface of the substrate.

Although the present embodiment has been explained based on the relationship of the substrate 130 being above and the mold 110 being below with respect to the direction of the z axis as was previously described, it can be easily understood by a person with ordinary skill in the art that the present embodiment can also be carried out based on the positional relationship in which the vertical relationship of substrate 130 and mold 110 is reversed.

### Pattern Formation Device According to the Present Invention

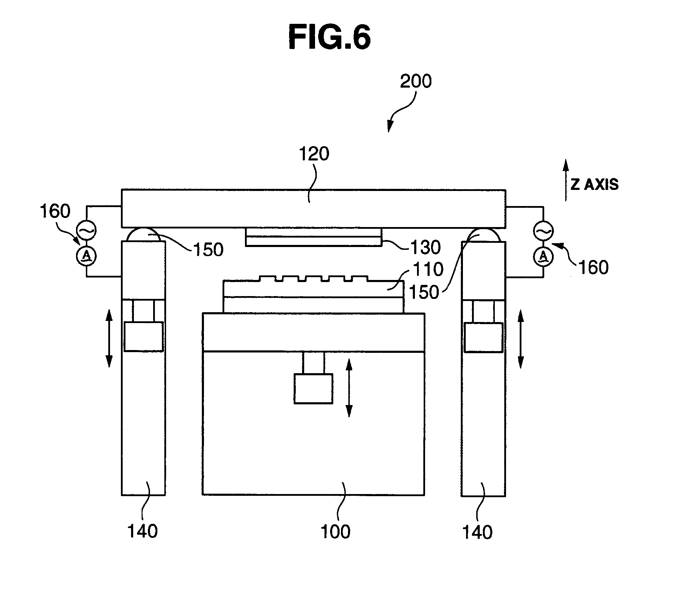

Fig. 6 is a schematic cross-sectional view of a pattern formation device for carrying out the pattern formation method embodying one embodiment according to the present invention. The pattern formation device 200 according to the present invention comprises a first actuator 100 for mounting a mold 110 and capable of freely moving vertically in the direction of the z axis, and a sample base 120 arranged in opposition to first actuator 100 for mounting a substrate 130 on which is provided a resist film. Moreover, the device 200 is provided with at least two supports 140 which are able to control the positional relationship of the sample base 120 and the mold 110 and move the sample base 120 vertically in the direction of the z axis. Here, the supports 140 are provided with a second actuator 150 on the ends thereof, and are required to precisely control the positional relationship between the substrate 130 arranged on the sample base 120 and the mold arranged on the first actuator 100. Thus, a stepping motor actuator (movement width: 25 mm, resolution: 25 nm, PI-Polytech Model M168), for example, is used for the first actuator 100 used in the present invention. On the other hand, a preferable example of the second actuator 150 used in the present invention is the piezo actuator disclosed in US Patent No. 5,410,206, specific examples of which include the Model 8301, 8302, 8303, 8321 or 8322 manufactured by New Focus Inc. having a linear resolution of 30 nm or less. The use of such an actuator makes it possible to maintain parallelism between the substrate 130 and the mold 120 while also accurately controlling the movement of the mold 120 in the direction of the z axis.

It is necessary to not disturb the parallel positional relationship during contact between the supports 140 and the sample base 120. In other words, it is necessary detect contact between the supports 140 and the sample base 120 with high precision. Thus, the pattern formation device 200 according to the present invention is provided with a monitoring unit 160 that employs the supports 140 and sample base 120 as conductors and that connects with a current source and an ammeter between the supports and the sample base. The monitoring of an amount of current by this monitoring unit 160 makes it possible to detect contact between the supports 140 and the sample base 120 with high precision. In the present invention, an alternating current source is preferably used for the current source to eliminate the effects of noise on the monitoring unit. The use of this monitoring unit 160 makes it possible to control the positional relationship between the supports 140 and the sample base 120 in the pattern formation device according to the present invention at a precision of about 10 nm.

### Example

Although the following provides a more detailed explanation of the present invention through embodiments thereof, the present invention is not limited to these embodiments. A person with ordinary skill in the art is able to work the present invention by adding various changes to the following embodiments, and the changes are included in the scope of claim for patent of the present application.

A silicon substrate was produced by anisotropic etching, and a mold was produced by nickel electroforming having a pitch of 1.25 µm and height of 0.71 µm.

Polystyrene (to be abbreviated as PS) was used for the resist film, and after dissolving in a suitable solvent, the resulting solution was spin-coated onto a glass substrate. Next, the glass substrate was dried in a vacuum oven to form a resist thin film having different film thicknesses. (1 µm and 200 nm). After drying, the glass substrate was mounted on a sample base arranged on the z axis, and a pattern was formed at a mold temperature of 130°C.

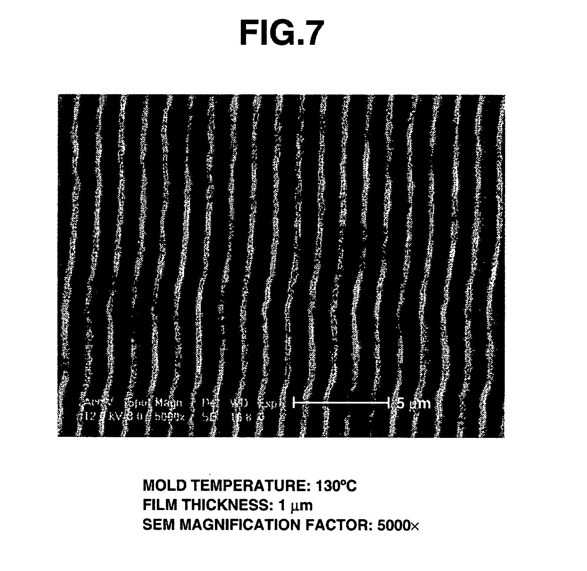

Fig. 7 shows an SEM micrograph (magnification factor: 5000x) of a pattern formed using a resist film thickness of 1 µm. According to the result shown in Fig. 7, since the thickness of the resist film is 1 µm and the mold depth is 710 nm, the resist film thickness is greater than the depth of the mold. Consequently, since the resist has reached the bottom of the mold, pattern deformation can be seen to have occurred during mold separation.

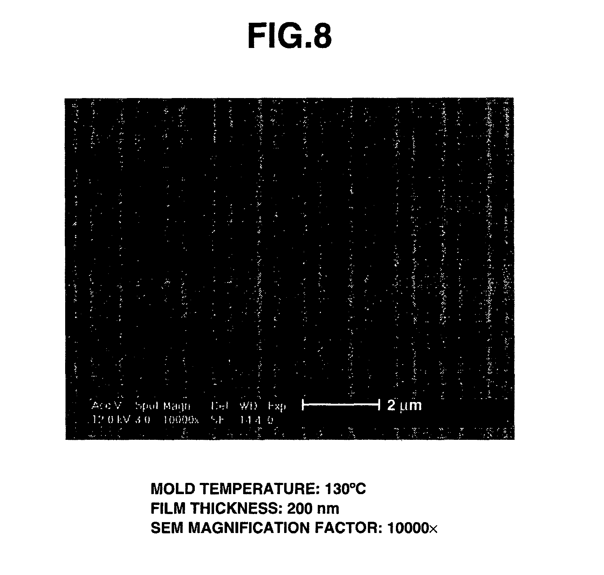

Fig. 8 shows an SEM micrograph (magnification factor: 10,000x) of a pattern formed according to the pattern formation method of the present invention using a resist film thickness of 200 nm. The result of Fig. 8 confirms that, since the thickness of the resist film of 200 nm is less than the mold depth of 710 nm, contact between the bottom of the mold and the resist film is avoided, and there is no occurrence of pattern deformation caused by mold separation.

## Claims

1. A method for forming a pattern in a resist film on a substrate by using a first mold provided with concave and convex portions, comprising the steps of:
(1) pressing the first mold onto the resist film to transfer the concave and convex portions of the first mold to the resist film, while heating the first mold to a predetermined temperature or after having heated the first mold to a predetermined temperature;
(2) separating the first mold from the resist film; and
(3) etching the resist film to expose a surface of the substrate.

2. The method according to Claim 1, wherein the pressing step is carried out so that a bottom of the concave portion avoids contacting with a surface of the resist film.

3. The method according to Claim 1 or 2, wherein a hardness of the first mold is higher than a hardness of the resist film.

4. The method according to any one of Claims 1 to 3, wherein the predetermined temperature of the first mold in the pressing step is equal to or substantially equal to a glass transition temperature of the resist film.

5. The method according to any one of Claims 1 to 4, wherein the first mold comprises silicon or is formed by electroforming using the silicon as a master.

6. The method according to any one of Claims 1 to 5, wherein the resist film comprises a thermoplastic resin.

7. The method according to any one of Claims 1 to 6, wherein the etching step is carried out by reactive ion etching.

8. The method according to any one of Claims 1 to 7, wherein in a case where there are variations in a pattern density of a pattern to be formed in the resist film on the substrate by the first mold, the method comprises a pretreatment step in which the resist film is pressed in advance using a second mold so that a thickness of the resist film in a case where numerous regions pressed by the convex portions of the first mold exist is less than a thickness of the resist film in a case where few regions pressed by the convex portions of the first mold exist.

9. The method according to Claim 8, wherein the second mold in the pretreatment step is pressed onto the resist film while heating the second mold to a predetermined temperature or after having heated the second mold to a predetermined temperature.

10. The method according to Claim 8 or 9, wherein a hardness of the second mold is higher than a hardness of the resist film.

11. The method according to any one of Claims 8 to 10, wherein the predetermined temperature of the second mold in the pretreatment step is equal to or substantially equal to the glass transition temperature of the resist film.

12. The method according to any one of Claims 8 to 11, wherein the second mold comprises silicon or is formed by electroforming using the silicon as a master.

13. A method for forming a pattern in a resist film on a substrate by using a mold provided with concave and convex portions, comprising the steps of:
(a) arranging the mold on a vertically moving actuator;
(b) mounting the substrate on a sample base arranged in opposition to the actuator so as to oppose the mold;
(c) mounting the substrate on the mold;
(d) supporting the sample base having the substrate by a support; and
(e) moving the actuator so that the mold moves away from the resist film.

14. The method according to Claim 13, further comprising a step (f) of moving the actuator so that the mold and the resist film make contact while heating the mold to a predetermined temperature or after having heated the mold to a predetermined temperature.

15. The method according to Claim 14, further comprising a step (g) of moving the actuator so that the mold separates from the resist film.

16. The method according to Claim 15, further comprising a step (h) of etching the resist film to expose a surface of the substrate.

17. The method according to Claim 14, wherein the step (f) is carried out so that a bottom of the concave portion of the mold avoids contacting with a surface of the resist film.

18. The method according to any one on of Claims 13 to 17, a hardness of the mold is higher than a hardness of the resist film

19. The method according to any one of Claims 14 to 17, wherein the predetermined temperature of the mold is equal to or substantially equal to the glass transition temperature of the resist film.

20. The method according to any one of Claims 13 to 19, wherein the mold comprises silicon or is formed by electroforming using the silicon as a master.

21. The method according to any one of Claims 13 to 20, wherein the resist film comprises a thermoplastic resin.

22. A pattern formation device for forming a pattern in a resist film on a substrate using a mold provided with concave and convex portions, comprising:
a sample base for mounting the substrate;
a first actuator arranged in opposition to the sample base for moving the mold;
at least two supports for supporting the sample base;
a second actuator arranged on the support for vertically moving the sample base; and
a monitoring unit for monitoring a contact between the support and the sample base.

23. The pattern formation device according to Claim 22, wherein the monitoring unit monitors an amount of current flow by using the support and sample base as conductors and connecting a power supply therebetween.

24. The pattern formation device according to Claim 23, wherein the power supply is an alternating current power supply.
